# EUROPEAN PATENT APPLICATION

(11) **EP 2 965 850 A1**
(43) Date of publication of application: **13.01.2016**
(21) Application number: 14468006.3
(22) Date of filing: 11.07.2014
(51) Int. Cl.: B23K 20/12, B23K 20/233, B23K 33/00, H01L 23/473

(54) **Friction stir welding joint design and method for manufacturing cooling devices for electronic components**

(71) Applicant: NELA Razvojni center d.o.o. Podruznica Vincarje, 4220 Skofja Loka (SI)
(72) Inventor: Muhi?, Tadej, 8000 Novo mesto (SI); Kumer, Miha, 1000 Ljubljana (SI); Podlipnik, Gregor, 4220 ?kofja Loka (SI); Megu?AR, Andrej, 4227 Selca (SI)
(74) Representative: Macek, Gregor

(57) **Abstract**

The present invention provides a novel joint design and method for the prevention of product leakage and for precise positioning of die-cast components for electronic cooler applications, welded together using the friction stir welding process. The object of the invention is the design of the interface edges which prevents leakage of final component resulting from the entrapped porosity in the parts, and enables an easy, precise and repeatable assembly of components with greater thickness of the joint. The method for prevention of deformations of the assembled parts during pressure peaks in operational use is also provided.

## Description

### FIELD OF INVENTION

The present invention relates to a joint design and a friction stir welding method for manufacturing cooling devices for electronics, made of two aluminum parts produced using the high-pressure die-casting method. The friction stir welding method is employed to combine the parts into a leakage-tight assembly.

### BACKGROUND OF INVENTION

Friction stir welding (FSW) process belongs to the category of solid-phase joining methods. This means that only downward pressure and rotating action of the welding tool is used for the welding process. Due to the applied mechanical deformation and a rotating action of a welding tool, the material inside the weld region of two members is not melted, instead it is pressured and stirred together. In this way a permanent weld is created. The FSW process has many advantages and can be applied for various materials types, especially for combining two materials of different type. A detailed description of the FSW process is found in European patent application EP0752926 B1.

In EP 1 568 434 A1 patent application, a solution for FSW embodiment for extruded profiles for automotive structural parts is presented. The improvement is realised with different protrusions of the profiles in the welding region. In addition, special support ribs are positioned in places where support is needed during the FSW process.

In US 6,045,027 patent, a different solution for joint embodiment on two-dimensional plates is shown. The improvement is a different design of interface edges as an N-shape and a square shape of profile, which induces interlocking of the plates. In addition, consumable pins can be inserted along the mated interfaces for holding the work pieces together.

The designs solutions of the joint edges in the patents EP 1 568 434 and US 6,045,027 are applicable only for parts which are produced with the extrusion or rolling process and when there is no demand for tightness.

In patent applications US 2011/0308059 A1 and WO 2013094246 A1, a solution of joint embodiment for a liquid cooler for electronics is presented. The edge form is designed as a one step support. The presented solution is based on the assumption that the welding depth is greater than the thickness of the cover.

This solution of one-step joint embodiment is applicable only in case the thickness of the cover is smaller compared to the welding (i.e. penetration) depth of the welding tool. Based on the max. ratio (2:1) of the diameter of the shoulder to the diameter of the welding pin, greater welding depths cannot be achieved in cases where the space for the welding tool path is limited due to the presence of different mounting features or emptying holes for cable crossing on the product, as well as when the thickness of the cover cannot be changed due to design requirements. In these cases, the proposed design is not applicable due to the risk of leakage of die-cast assembly, as explained further below.

Secondly, in patent application US 2011/0308059 A1 short temporary welds for the purposes of positioning accuracy are presented. This solution is time consuming and induces additional deformation of the cooler assembly. This solution is not feasible for serial production.

Thirdly, in patent application US 2011/0308059 A1 a sequence of linear welds in the middle of the cooler is presented. In covers of greater thickness, the weld penetration depth is too low. In addition, the space required for welding tool is too small to cross over the whole length of the channel separation rib because of the mounting columns for electronics.

There exists a need to develop a joint interface design on die-cast parts that realizes an easy, cheap and accurate assembly of the parts without further processing. So far there is no known solution for cooling unit joint design that provides a completely sealed joint regardless of the thickness of the cover, due to the presence of an oxide film on the die-cast parts. Also, any deformations of the cover during the life time of the cooler must be prevented.

### BRIEF SUMMARY OF INVENTION

An object of the present invention is to provide a design of the joint for the die-cast parts, which enables the friction stir welding process to produce completely water tight parts for cooler housings for electronics.

Another object of the present invention is to provide a joint design which enables an easy and repeatable assembly of components and a constant gap width across the welding trajectory.

Another object of the present invention is to provide a joint design for the purpose of fixation and prevention of deformations during the lifetime of the components.

To solve the above problem, a special two-step design of the welding joint was developed. A two-step joint design enables the production of die-cast aluminum components for water-tight cooling housings.

First step: shaping of the joint surface to provide a joint interface in the form of a stepped joint by means of the milling process; only a certain proportion of the joint surface is machine processed by milling in order to prevent any surface oxide from entering the weld region and affecting the quality of the weld. In this way, the oxide layer which forms on the surface of the die-cast part beneath the welding depth stays intact, which consequently provides sealing, i.e. a protective surface on the walls of the cooling channel, even in the case of porosity in the walls of the die-cast part.

Second step: distribution of triangular ribs across the machined joint line by means of milling to enable an easy and repeatable assembly of the two parts, i.e. positioning of cover with respect to the cooler base plate, prior to welding with a uniform joint gap across the weld trajectory.

The two parts are then welded together in an improved friction stir welding process according to the invention, wherein a spot weld is employed on a circular support rib to increase the structural integrity of the cooler and prevent deformation of assembled components. In addition, a welding strategy for the spot weld is presented. With this novel strategy of spot welding, increased load on the weld is possible.

For the purpose of said invention, the term "machined" refers to processing by milling.

### BRIEF DESCRIPTION OF THE DRAWINGS

FIG 1. Exploded view of components, which assembled and welded together represent a cooler for electronic components according to the invention
FIG 2. Schematic perspective and cross-sectional view of mechanical preparation, i. e. milling of joint surface before the FSW process (Prior Art)
FIG 2.1. Joint cross-sectional view of the two components assembled together before the FSW process (Prior Art)
FIG 2.2. Joint cross-sectional view of the two components during the FSW process (Prior Art)
FIG 3. Schematic perspective and cross-sectional view of the improved joint design and mechanical preparation of joint before the FSW process according to the invention
FIG 3.1. Joint cross-sectional view of the two assembled parts before FSW process according to the invention
FIG 3.2 Joint cross-sectional view of the two assembled parts during FSW process according to the invention
FIG 4. Schematic representation of a joint with triangular shaped ribs for positioning of a cover with respect to the cooler according to the invention
FIG 4.1. Detailed schematic perspective view illustrating the triangular rib design on the joint line for positioning purposes according to the invention
FIG 5. Schematic representation of a welding path in the middle of the cooler (Prior art)
FIG 6. Schematic representation of a spot weld path in the middle of the cooler according to the invention
FIG 7. Spot weld cross-sectional view according to the invention compared to prior art.

### DETAILED DESCRIPTION OF THE INVENTION

The present invention provides a novel joint design for a friction stir welding and improved friction stir welding method for manufacturing cooling devices for electronics made by die casting method.

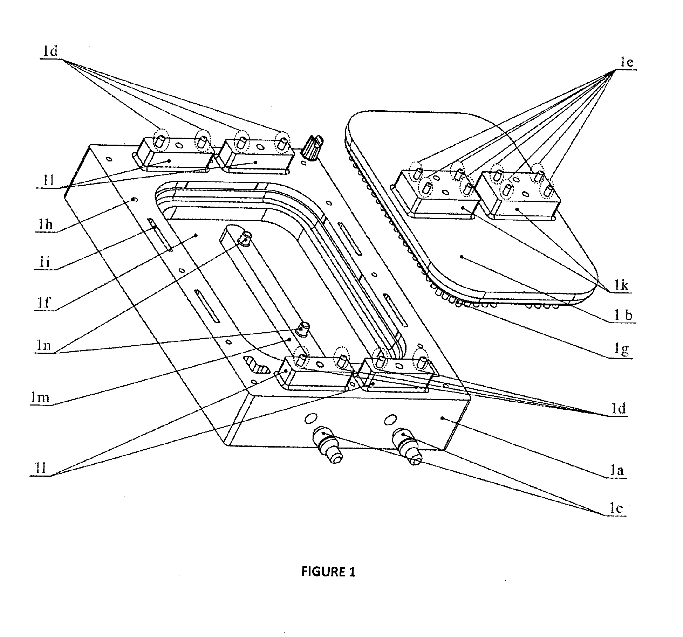

FIG. 1 illustrates different components which form a cooler device. The first component 1 a represents a cooler base plate with different features: 1 i - emptying holes for crossing of electric cables from top surface to bottom surface; 1 h - mounting holes for screws to mount an additional cover to prevent the oxidation of electronic components; 1 d - pins for precise positioning of electronic components on the cooler plate; 1 l - mounting rib for electronic parts on a cooler plate; 1 f - cooling channel; 1 m - rib which separates the inlet and outlet flows of a cooling medium; 1 n - spot-welded supports for the prevention of cover deformation during the operation.

The second component represents a cooler cover 1 b with a cooling structure in the form of pins 1 g which increases the cooling capacity. On top of the cover there are also mounting ribs 1k for electronic parts. In addition, precise positioning pins 1 e are positioned on the mounting rib 1 k, which have to meet precise positioning tolerances with respect to the positioning pins 1 d on the base plate 1 a.

The third component presents water connectors 1 c for a connection between the cooling channel 1f and a piping system.

The design of the die-cast parts 1 a and 1 b is done in a way to optimize the heat transfer from electronic components and to withstand dynamical pressure loads due to pressure peaks over the product life time. This means that the design of the part is not optimized primarily for the die casting process of aluminum. The die casting process has an advantage of low cost production, but also has a disadvantage of potential porosities 2.1 mp, especially with bigger wall thicknesses. The presence of porosity in areas near the mounting holes may cause leakage of cooling media from the cooling channel 1 f through porosity 2.1 mp and mounting holes 1 h for mounting the cooling device. Any leakage of cooling media must be avoided, because it causes short circuit on the electronic components.

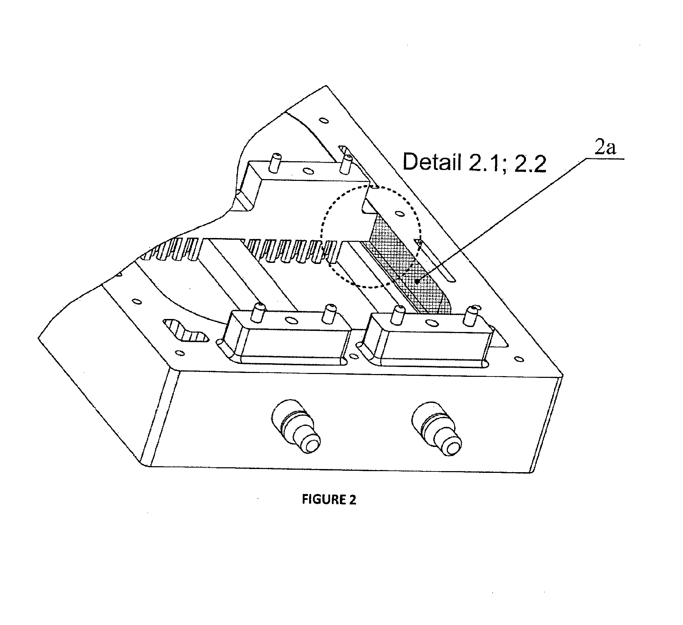

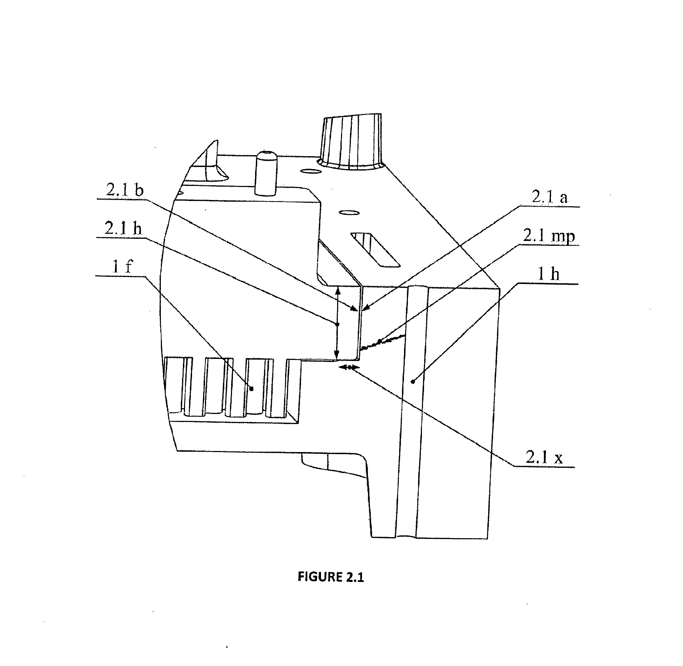

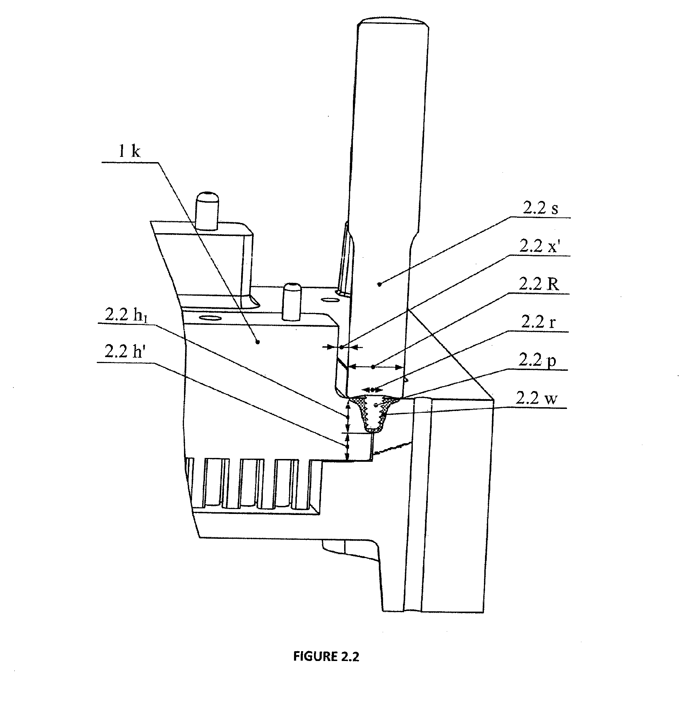

This type of porosity is called shrinkage micro porosity 2.1 mp and is often present in the middle area of the thick wall as shown on Figure 2.1. Porosity is not present in the area close to the wall surface. Porosity is usually revealed by the machining process, i.e. milling, when preparing the joint interfaces 2.1 a and 2.1 b. Joint interfaces, i.e. edges, are machined, i.e. milled, to a defined height 2.1 h and width 2.1 x, which corresponds to the thickness of the cover 1b in the joint area, in order to remove surface oxides from the welding surface and to mill away the die casting wall slopes on both parts for the purpose of part assembly. Machining of the cooling device edges is presented on Fig. 2 and designated 2 a. By machining of joint interfaces, the porosity inside the walls is opened and a die casting skin is removed from the joint surfaces. The die casting skin is a surface phenomenon, which consists of different oxides and also represents a leakage protection barrier.

Fig. 2.2 presents prior art FSW welding. FSW tool shoulder 2.2 s and pin 2.2 p form the weld region 2.2 w with welding depth 2.2 h₁. Underneath the weld region a non-welded machine-made joint interface area 2.2 h' is located, through which cooling media can pass from the cooling channel 1 f towards the porosity 2.1 mp and the mounting hole 1 h. The design of the die-cast part prevents the enlargement of the welding depth 2.2 h₁ due to the limitation of space 2.2 x' between the welding shoulder 2.2 s and the mounting rib 1 k for electronic parts on cover 1 b. The ratio of the diameter 2.2 R of the shoulder 2.2 s to the diameter 2.2 r of the pin 2.2 p at the lower boundary is 2:1. This affects the capability of reaching the maximum welding depth 2.2 h₁. A prolongation of the welding depth 2.2 h₁ with given welding tool dimensions 2.2 R and 2.2 r due to the given clearance 2.2 x' would result in breakage of the tool due to known ratios.

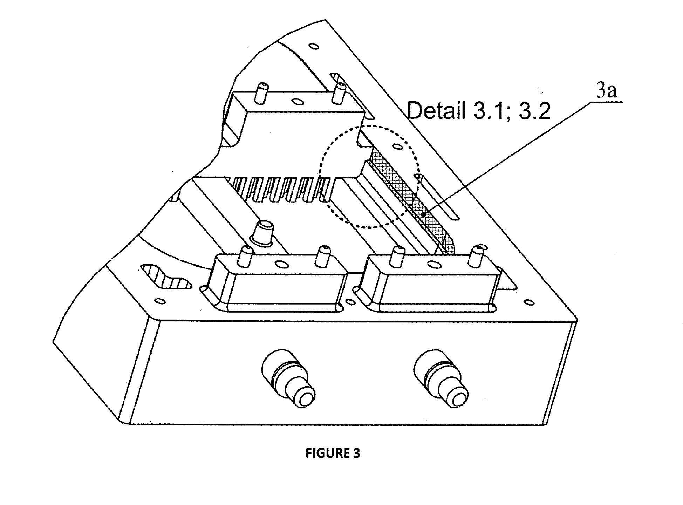

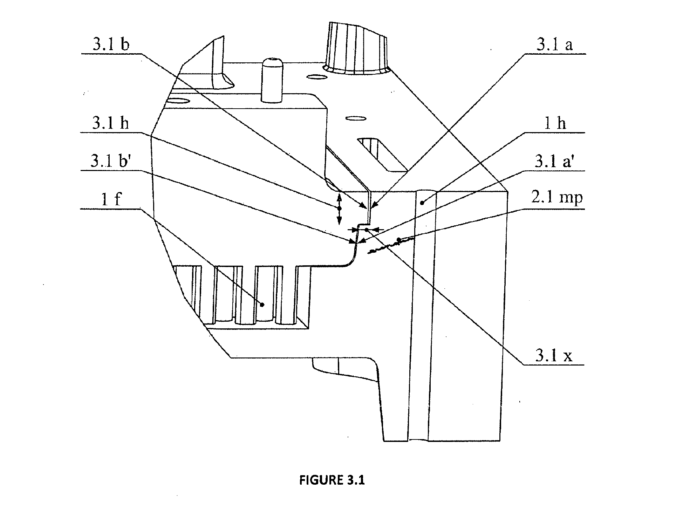

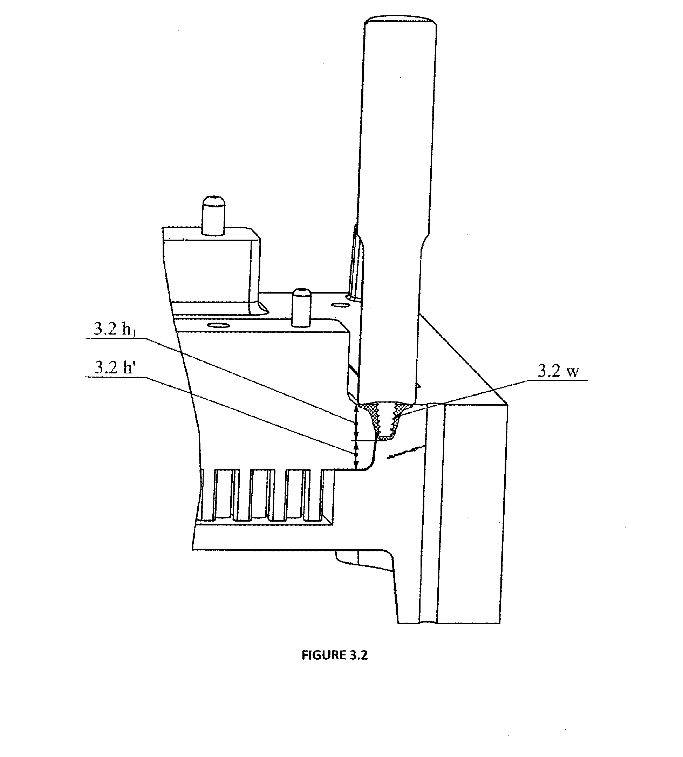

To avoid the above disclosed disadvantages of prior art, the joint weld design according to the present invention was developed and is presented on Fig. 3. The machining of the cooler edges is marked 3 a. The machining area of the cooler plate joint edge 3.1 a and the cover joint edge 3.1 b is presented in a cross-sectional detailed view on Fig. 3.1. The cooler plate joint edge 3.1 a on the cooler plate 1 a is shaped as a step against which the knee-shaped cover joint edge 3.1 b of the cover 1 b rests. Due to such design of the joint weld, the height 3.1 h of the machined edge is lower than the height 2.1 h of the machined edge in the prior art, while the thickness of the cover remains the same. Also, the width 3.1 x of the machined edge, i. e. the removed surface oxides, according to the present invention is smaller than the width 2.1 x in prior art. Since the cooler plate and the cover are pre-casted and no machining is performed on the rest of the joint's interface area, i.e. the edge 3.1 a' on the cooler plate 1 a and the edge 3.1 b' on the cover 1 b, the surface oxide skin on edges 3.1 a' and 3.1 b' stays intact. Due to a lower machining depth, the micro porosity 2.1 mp is not revealed by machining and remains in the middle of the wall. Also, due to the intact oxide film on the edges 3.1 a' and 3.1 b' additional protection against leakage from the cooling channel 1 f towards the micro porosity 2.1 mp and the mounting hole 1 h is provided. Figure 3.2 presents weld region 3.2 w with welding depth 3.2 h₁. It can be seen that welding depths 2.2 h₁ and 3.2 h₁ are the same, but due to the joint design according to the invention, the machined areas 3.1 a and 3.1 b are inside the welding region 3.2 w and thus completely mixed and sealed by the welding tool. The welding depth 3.2 h₁ is higher than the machining depth 3.1 h. Underneath the weld region 3.2 w, an unprocessed joint line with height 3.2 h' exists. In this way, an oxide film is provided over the entire surface of the cooling channel and consequently tightness is provided despite the presence of the inner porosity in the die-cast part. This effect is achieved with no changes to the dimensions of the welding tool. Furthermore, the machining costs are significantly reduced.

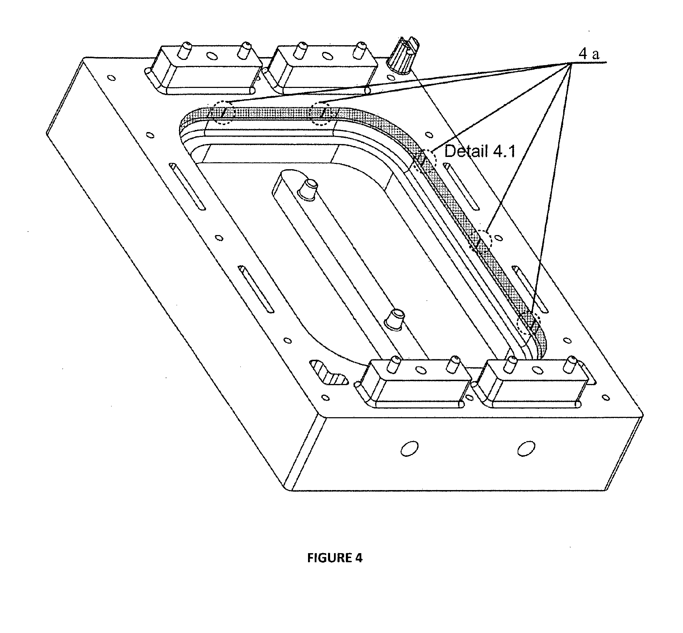

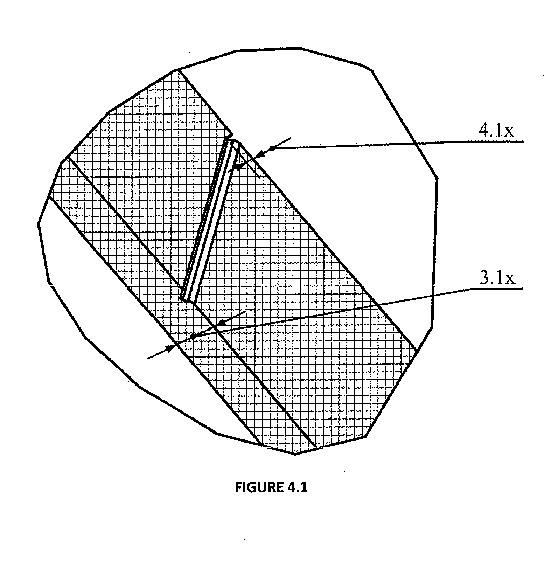

Figures 4 and 4.1 present the specially designed ribs 4 a. Ribs are also machined, i.e. milled, prior to the welding sequence, and are of a triangular shape and uniformly distributed along the whole joint length. Ribs 4a are provided on the joint edge 3.1 a.

The first purpose of the machined ribs 4 a on the joint interface is to achieve an equal gap size along the welding trajectory. The nature of the FSW process induces high forces in all directions, especially in the direction of welding. These forces have a tendency to push the cooler cover plate 1 b in the direction of welding. This movement in turn induces change in joint gap size along the joined surfaces. Unequal joint gap size causes welding faults like void formation and weld underfill which are well-known and unacceptable weld quality faults in application of FSW for coolers.

The ratio of the width 4.1 x of the rib 4 a to the width 3.1 x of the machined edge enables an easy assembly of the cooler cover 1 b and the cooler plate 1 a, even with a relatively large joint thickness without a need to force the both parts to assemble.

The second purpose of machined ribs 4 a is to provide exact positioning of the mated joint interfaces. In this way, the exact positioning of the cover positioning pins 1 e with respect to the cooler base plate positioning pins 1 d is achieved after the FSW process is finished. Additional machining of the welded parts at those two positions is avoided.

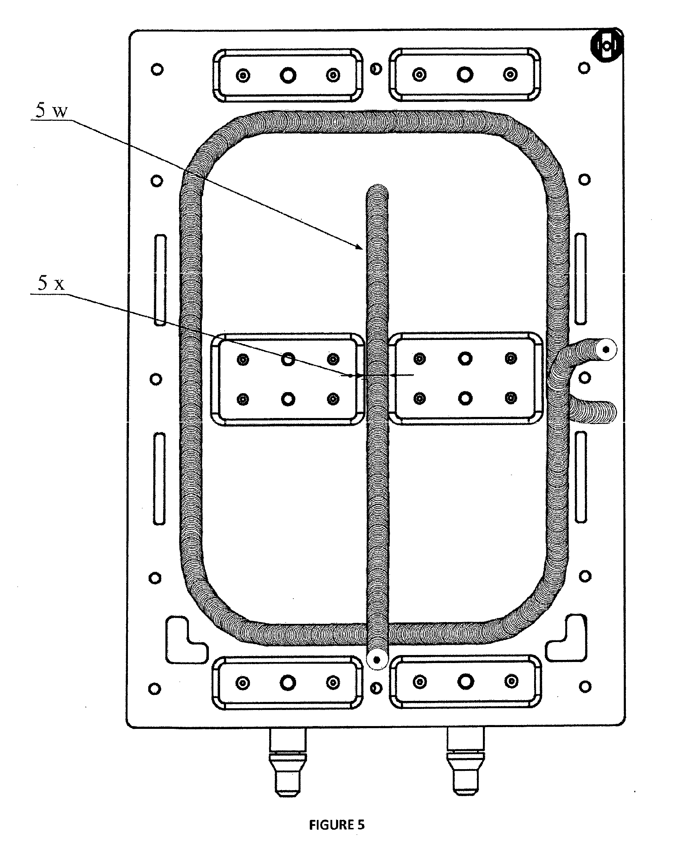

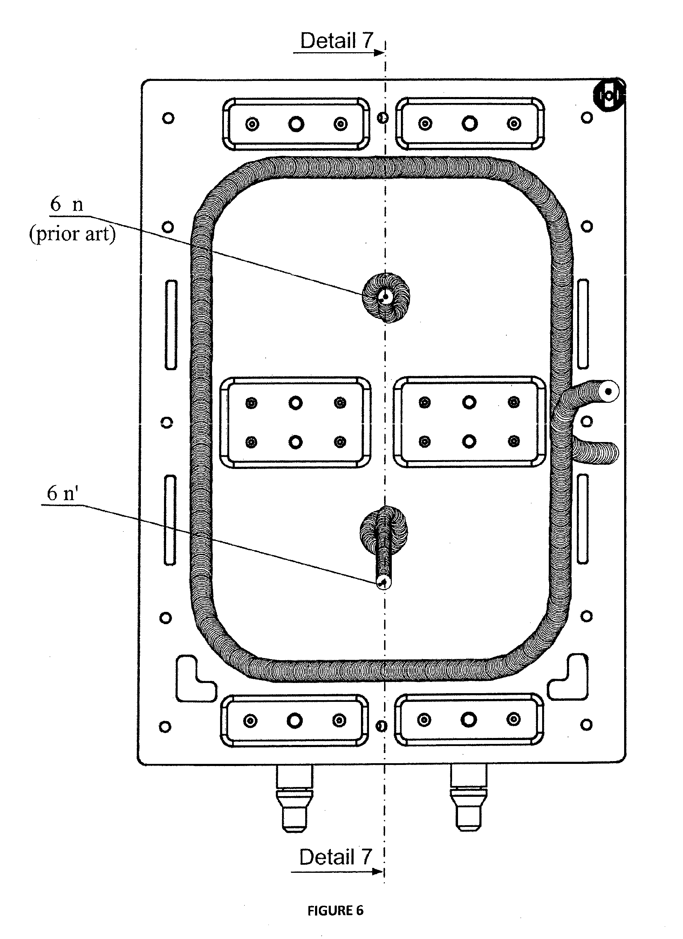

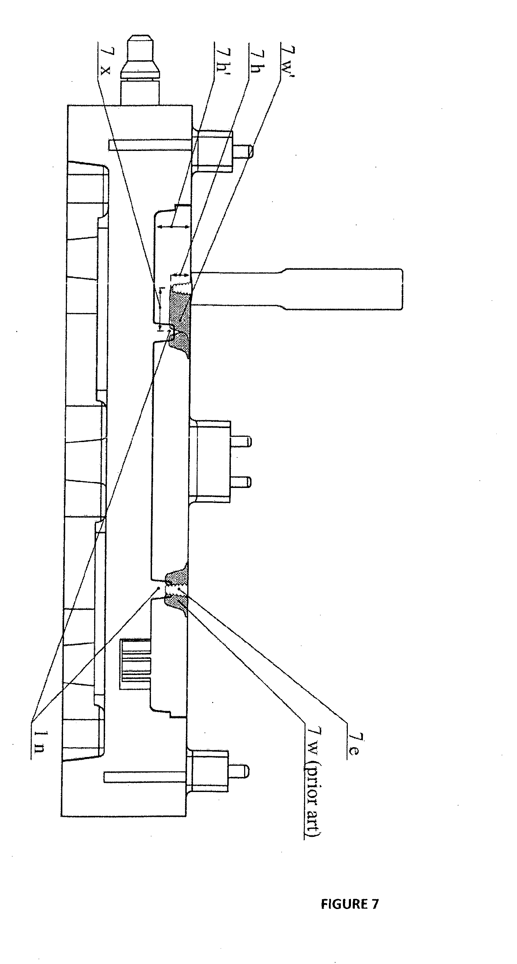

Figures 6 and 7 present the improved friction stir welding method for manufacturing cooling devices for electronics made using the die casting method. Due to limited space on the cover, linear joint 5 w in the center of the cooler cannot be used, because the space 5 x between the mounting rib 1 k for electronic parts on cover 1 b is too small to use the welding shoulder with diameter 3.2 R as shown in Figure 5. In order to prevent deformations of the cover during the operational cycle, which may cause a reduction of contact surface between the electronic parts and the cooling surface, two spots welds 6 n' and 6 n instead of one linear weld 5 w are employed. In this way, the overall stiffness of the cooler during pressure peaks is achieved. A spot weld support is shaped as an additional circular elevated rib 1 n on the existing rib 1 m which separates the inlet and outlet flows of cooling medium. In this way, the weld is formed despite the thickness of the cover 7 h' being greater than the maximum welding depth 7 h reachable under the given space limitations. The welding area for the spot welds is marked with 7 w and 7 w', whereby 7 w represents the prior art welding area and 7 w' represents the welding area according to the invention.

The welding strategy for the spot welds 6 n and 6 n' is presented in Figure 6. In the spot welding strategy known from prior art a circular welding path is used. The exit hole 7 e of welding tool is in the centre of the circular rib 1 n. With the improved welding method, the spot welding strategy is modified, i.e. the circular welding path is prolonged from the center of the circular rib 1 n for a necessary distance 7 x. In this way, the risk of weld failure and consequential leakage is reduced due to an increased distance between the cooling channel and the weld exit hole.

## Claims

1. A friction stir welding joint design for manufacturing cooling devices for electronic components, made of two aluminum parts which are produced using the high pressure die casting method, **characterized in**:
- the shaping of the joint interface in the form of a stepped joint by means of a milling process, whereby only a defined proportion of the joint surface is machine processed to prevent any surface oxide from entering the weld region, and the oxide layer which forms on the surface of the die-cast part beneath the welding region stays intact;
- the distribution of the triangular ribs across the machined joint line by means of milling, to enable positioning of the cover with respect to the cooler base plate, prior to welding with a uniform joint gap across the weld trajectory.

2. A joint design according to claim 1, **characterized in that** the cooler plate joint edge 3.1 a on the cooler plate 1 a is shaped as a step against which the knee-shaped cover joint edge 3.1 b of the cover 1 b rests; the triangular ribs (4 a) are distributed uniformly along the whole length of the joint edge (3.1 a), and a spot-welded support shaped as an additional circular elevated rib (1 n) is made on the existing rib (1 m).

3. A joint design according to claims 1 and 2, **characterized in that** the joint edges (3.1 a) and (3.1 b) are machine processed by milling to the height (3.1 h) and width (3.1 x) and are located inside the welding region (3.2 w) with the height (3.2 h₁); no milling is performed underneath the welding region (3.2 w), on the edge (3.1 a') on the cooler plate (1 a) and the edge (3.1 b') on the cover (1 b), thus the surface oxide skin on edges (3.1 a') and (3.1 b') stays intact.

4. A friction stir welding method for manufacturing cooling devices for electronic components, used for welding of joint design according to claims 1 to 3, **characterized in that** after the joint edges (3.1 a, 3.1 b) and ribs (4 a) are machined by milling, welding of the joint edges (3.1 a, 3.1 b) is performed and additionally spot welding with two spots welds (6 n') is performed, whereby the circular welding path is prolonged from the center of the circular rib (1 n) for a distance (7 x) to increase the distance between the cooling channel (1 f) and the weld exit hole (7 e) in order to increase the mechanical strength of the spot welds (6 n') in comparison to prior art spot weld (6 n).
